# EUROPEAN PATENT APPLICATION

(11) **EP 1 557 874 A2**
(43) Date of publication of application: **27.07.2005**
(21) Application number: 04019988.7
(22) Date of filing: 23.08.2004
(51) Int. Cl.: H01L 21/3065, H01L 21/306

(54) **Method for etching high aspect ratio features in III-V based compounds for optoelectronic devices**

(30) Priority: 26.01.2004 US 765647
(71) Applicant: Agilent Technologies, Inc., Palo Alto, CA 94306 (US)
(72) Inventor: Mirkarimi, Laura Wills, Sunol California 94586 (US)
(74) Representative: Liesegang, Eva

(57) **Abstract**

RIE etching of III-V semiconductors is performed using HBr or combinations of group VII gaseous species (Br, F, I) in a mixture with CH₄ and H₂ to etch high aspect ratio features for optoelectronic devices.

## Description

### CROSS-REFERENCE TO RELATED APPLICATIONs

This application is related to U. S. Patent Application Ser. No. 10/692772 filed October 24, 2003 and assigned to the same assignee.

### BACKGROUND

The ability to etch high aspect ratio features in III-V compounds with sidewalls steeper than about 88 degrees is important for applications in optical and electrical devices. Present approaches for etching high aspect features in III-V compounds including InP and GaAs typically use dry etching and incorporate inductively coupled plasma (ICP), electron cyclotron resonance (ECR), or chemically assisted ion beam (CAIB) etching. These approaches all use a combination of physical and chemical etching. Typical chemistries used are Cl, Ar, CH₄, H₂, SiCl₄, BCl₃.

The use of prior art etch approaches to fabricate photonic crystals typically leads to the problem that the mask material is degraded before the desired etch depth is achieved. The requirement for submicron feature size requires an etch approach with aspect ratios greater than 5 to 1. The typical small feature size and geometry of photonic crystal lattices requires many thin walled features in the mask that can be attacked by ions in a plasma and physically sputter the mask material away. As mask erosion progresses, the features of interest suffer from deformation and if mask erosion is severe, the desired etch depth may not be reached before the entire mask structure is eroded and the desired feature is lost.

### SUMMARY OF INVENTION

In accordance with the invention, Reactive Ion Etching (RIE) is combined with a bromine based chemistry to etch III-V based compounds such as InP. Mixtures of HBr with CH₄ and H₂ provide fast etch rates, vertical sidewalls and good control over the growth of polymers that arise from the presence of CH₄ in the mixture. Note that in accordance with the invention, HI or IBr or some combination of group VII gaseous species (Br, F, I) may be substituted for HBr. Typical values in accordance with the invention for the mixtures of HBr, CH₄ and H₂ are HBr in the range of about 2 to 75 percent, CH₄ in the range of about 5 to 50 percent and H₂ in the range of about 5 to 40 percent by volume at pressures in the range from about 1 to 30 mTorr. This allows fabrication of a variety of optoelectronic devices including photonic crystal structures.

### BRIEF DESCRIPTION OF THE DRAWINGS

FIGs. 1 a-c show steps for etching a III-V structure in accordance with the invention.
FIG. 2 shows an RIE reactor for use in accordance with the invention.
FIG. 3 shows a graph of etch rate versus pressure in accordance with the invention.
FIG. 4 shows a graph of CH₄ versus etch rate in accordance with the invention.
FIG. 5a shows etching in accordance with the invention.
FIG. 5b shows etching without CH₄.
FIG. 6a shows etching without H₂.
FIG. 6b shows etching in accordance with the invention.

### DETAILED DESCRIPTION OF THE INVENTION

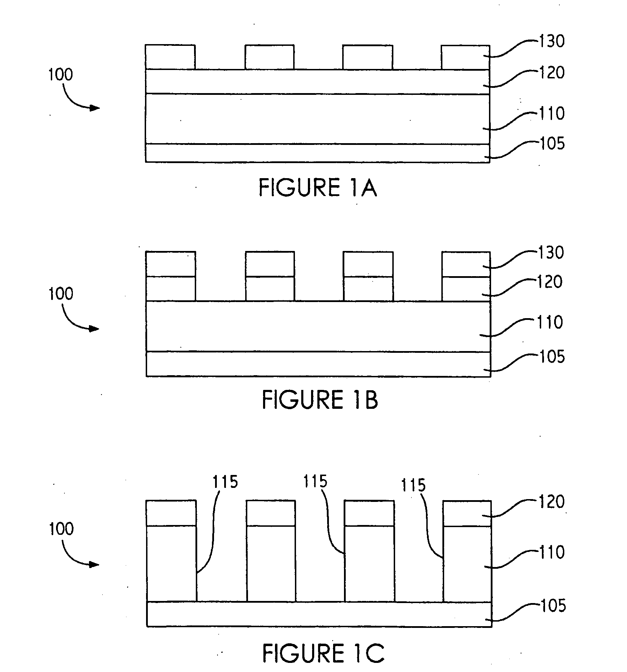

In accordance with an embodiment of the invention, appropriate mask layer 120 (See FIG. 1a), typically SiO₂ or Si₃N₄ is grown onto III-V epitaxial layer 110 or onto III-V substrate 105 of sample 100. Layer 130 is typically either photoresist or e-beam resist. Typical III-V materials are those that are combinations of Group III elements such as Al, Ga, In and B and Group V elements such as N, P, As and Sb. In accordance with the invention, the use of SiO₂ or Si₃N₄ mask 120 or other similar mask material offers etch selectivity between the mask material and the III-V material. Mask 120 is then typically defined lithographically by e-beam or other appropriate lithography suitable for making sub-micron features. In FIG. 1b, lithographic pattern in layer 130 is transferred into mask layer 120 using, for example, a dry etch technique containing CHF₃ in an RIE system. Sample 100 is then etched using an RIE system. Chemistries including CH₄, H₂ and HBr are used to properly transfer the defined features into III-V epitaxial layer 110. CH₄, H₂ and HBr gases together are required to obtain the desired high aspect ratio etching. In FIG. 1c, photoresist or e-beam resist layer 130 is removed using a solvent bath followed by a high pressure (400 mTorr) O₂ plasma clean.

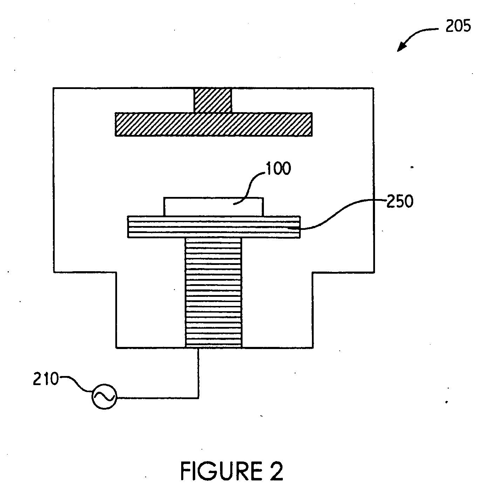

With reference to FIG. 2, typical values for reactor 205 in accordance with the invention are radio frequency (RF) generator 210 typically operating at about 13.56 MHz and in the power range of about 50 -200 watts with the DC (direct current) bias in the range from about 100-500 volts. Sample 100 is placed on heater 250 and heated to about 60 °C for InP based materials although it is expected that the actual temperature may be higher during the etch. The temperature setting is determined by the material being etched and may be higher or lower for other III-V materials. The pressure inside reactor 205 is typically set in the range from about 1- 30 mTorr.

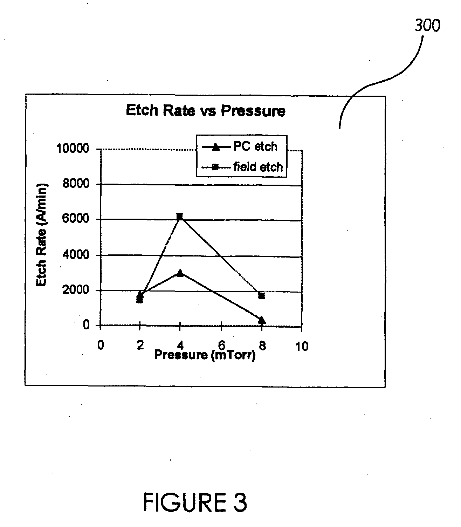

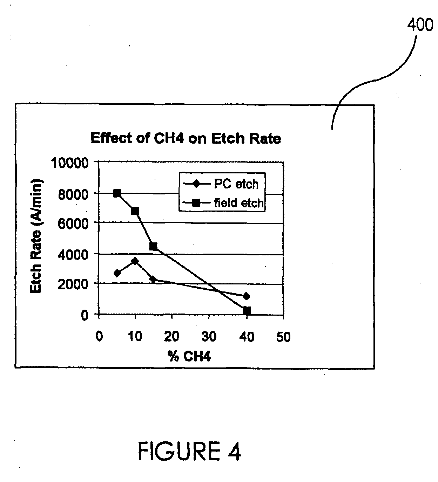

Graph 300 in FIG. 3 shows the etch rate of an InP sample as a function of pressure in accordance with the invention. It is apparent that there is a peak in etch rate for the photonic crystal region and the field region when pressure in reactor 205 is in the vicinity of 4 mTorr. Graph 400 in FIG. 4 shows the effect of the etch rate of an InP sample as a function of the percentage of CH₄ in accordance with the invention. As the percentage of CH₄ is increased the percentage of HBr is decreased while the ratio of CH₄:H₂ is maintained at about 2:1. It is apparent from graph 400 in FIG. 4 that higher etch rates are obtained for lower concentrations of CH₄.

Replacing chlorine based chemistry with bromine based chemistry in accordance with the invention typically results in bromine products that are more volatile than their chlorine counterparts. For example, InₓBr_{y} and GaₓBr_{y} products are more volatile than InₓCl_{y} and GaₓCl_{y} products. Additionally, HBr is self-passivating on vertical surfaces which allows the creation of high aspect ratio features. Aspect ratios greater than 10 may be obtained to construct optoelectronic devices in III-V materials. The regions of high etch rates may be defined for alternative etch chemistries to allow fabrication of a variety of optoelectronic devices which require vertical sidewalls and substantial etch depths such as, for example, microdisc resonators, VCSELs, edge emitting lasers, waveguides and photonic crystal structures. Note that in accordance with the invention, HI or IBr or some combination of group VII gaseous species (Br, F, I) may be substituted for HBr. The iodine (I) will typically behave similarly with the bromine (Br) and form a lower volatility salt with indium (In) compared to, for example, chlorine (Cl) and again form a passivation layer on vertical surfaces.

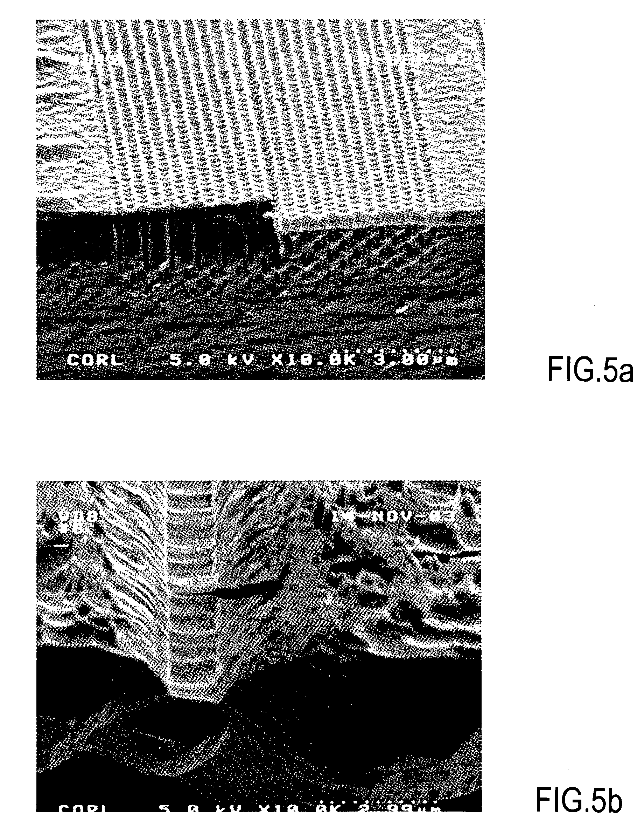

FIG. 5a shows a cross-sectional picture of SiO₂/InP sample 505 etched in a standard RIE system such as reactor 205 in FIG. 2 with RF 210 set to 13.56 MHz , a DC bias of 458 volts, power of 180 watts and at a temperature of 60 °C using an HBr, CH₄ and H₂ mixture of 39:39:22, respectively. FIG. 5b shows a cross-sectional picture of SiO₂/InP sample 510 etched in a standard RIE system such as reactor 205 in FIG. 2 with RF 210 set to 13.56 MHz, a DC bias of 458 volts, power of 180 watts and at a temperature of 60 °C using an HBr and H₂ mixture of 66:33, respectively. Comparing SiO₂/InP sample 505 with SiO₂/InP sample 510 shows that etching with only HBr and H₂ results in the loss of the desired submicron pattern (see FIG. 5b) due in part to the loss of selectivity between the photoresist and oxide masks and the InP.

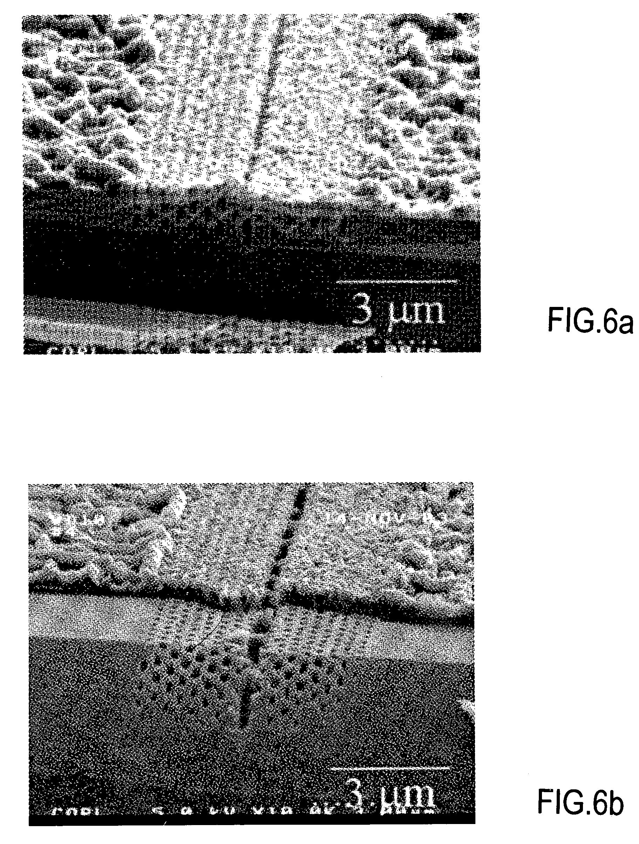

FIG. 6a shows a cross-sectional picture of SiO₂/InP sample 605 etched in a standard RIE system such as reactor 205 in FIG. 2 with RF 210 typically set to about 13.56 MHz , a DC bias of about 458 volts, power of about 180 watts and at a temperature of about 60 °C for 15 minutes using an HBr and CH₄ mixture of about 50:50, respectively, with an etch depth of pproximately 1.3 µm. FIG. 6b shows a cross-sectional picture of SiO₂/InP sample 610 etched in a standard RIE system such as reactor 205 in FIG. 2 with RF 210 typically set to about 13.56 MHz , a DC bias of about 458 volts, power of about 180 watts and at a temperature of about 60 °C for 15 minutes using an HBr, CH₄ and H₂ mixture of about 40:40:20, respectively, with an etch depth of approximately 2 µm. Comparing SiO₂/InP sample 605 with SiO₂/InP sample 610 shows that both the HBr, CH₄ and H₂ mixture and the HBr and CH₄ mixture etch the desired pattern into the InP. However, HBr, CH₄ and H₂ mixture provides an etch rate about 1.5 times faster than the HBr and CH₄ mixture. The addition of H₂ also provides a reduction in polymer buildup as seen by comparing sample 610 in FIG. 2b with sample 605 in FIG. 2a.

In accordance with the invention, a combination of CH₄, H₂ and HBr is used to enable a high chemical selectivity between the mask, such as mask 120, and the III-V material, such as III-V substrate 105, to be etched (see FIGs. 1a-c). Mixtures of CH₄, H₂ and HBr provide significantly better results when compared with the results achieved using either HBr and H₂ together or HBr and CH₄ together. Using CH₄, H₂ and HBr together in a mixture provides faster etch rates, higher aspect ratios for vertical surfaces and good control over the polymer growth resulting from the presence of CH₄ in the mixture. The specific combinations of both H₂ and CH₄ with HBr establish a balance between sidewall passivation, etch rate and soft-mask selectivity. This can not be easily accomplished using either CH₄ or H₂ alone in combination with HBr. Etching with mixtures containing H₂ and CH₄ typically results in polymer buildup and etching is limited to shallow etch depths for feature sizes in optoelectronic devices such as photonic crystal based devices. Etching with mixtures of H₂ and HBr results in the loss of the hardmask material such as, for example, SiO₂ and Si₃N₄ and the desired features of interest. Etching with a mixture of HBr and CH₄ typically produces an acceptable pattern but the etch rate is about a factor of two slower. The combination of CH₄, H₂ and HBr allows a balance of competing chemistries. Maintaining the appropriate balance is important for opto-electronic applications. For example, if the vertical nature of the holes is not preserved in photonic bandgap devices, the photonic bandgap is lost and the devices fail. Additionally, too much deposition of polymers associated with the presence of CH₄ distorts the desired pattern or results in problems in achieving a deep etch in the structure such as structure 100. Typical photonic bandgap devices fabricated in InP require etching to a depth of about 3 µm.

While the invention has been described in conjunction with specific embodiments, it is evident to those skilled in the art that many alternatives, modifications, and variations will be apparent in light of the foregoing description. Accordingly, the invention is intended to embrace all other such alternatives, modifications, and variations that fall within the spirit and scope of the appended claims.

## Claims

1. A method for etching a III-V semiconductor material comprising:
placing a semiconductor substrate on which said III-V semiconductor material has been deposited into a reactive ion etching reactor;
introducing a first gas chosen from HBr, HI and IBr into said reactive ion etching reactor; introducing a second gas of CH₄ into said reactive ion etching reactor;
introducing a third gas of H₂; and
exposing a portion of said III-V semiconductor material to be etched to a mixture comprising said first, said second and said third gas.

2. The method of Claim 1 further comprising the etching of vertical features into said III-V semiconductor material.

3. The method of Claim 1 or 2 further comprising the step of growing a mask onto said III-V semiconductor material.

4. The method of Claim 3 wherein said mask comprises silicon.

5. The method of Claim 4 wherein said mask is made of Si₃N₄.

6. A method for etching a III-V semiconductor substrate comprising:
placing said semiconductor substrate into a reactive ion etching reactor;
introducing a first gas chosen from HBr, HI and IBr into said reactive ion etching reactor;
introducing a second gas of CH₄ into said reactive ion etching reactor;
introducing a third gas of H₂; and
exposing a portion of said III-V semiconductor substrate to be etched to a mixture comprising said first, said second and said third gas.

7. The method of Claim 6 further comprising the step of etching vertical features into said III-V semiconductor material.

8. The method of Claim 6 further comprising the step of growing a mask onto said III-V semiconductor substrate.

9. The method of Claim 6 wherein the percentage of said first gas is in the range from about 2 to 75 percent by volume.

10. The method of one of the preceding Claims wherein the percentage of said second gas is in the range from about 5 to 50 percent by volume.

11. The method of one of the preceding Claims wherein the percentage of said third gas is in the range from about 5 to 40 percent by volume.

12. The method of one of the preceding Claims wherein said reactive ion etching reactor is maintained at a pressure in the range from about 1 to 30 mTorr.

13. The method of one of the preceding Claims wherein the DC bias for said reactive ion etching reactor is in the range from about 100 to 500 volts.

14. The method of Claim 2 or 7 wherein said vertical features have an aspect ratio greater than ten.
